# EUROPEAN PATENT APPLICATION

(11) **EP 3 434 815 A1**
(43) Date of publication of application: **30.01.2019**
(21) Application number: 18183171.0
(22) Date of filing: 12.07.2018
(51) Int. Cl.: C25D 17/00, C25D 21/12

(54) **DISTRIBUTION SYSTEM FOR CHEMICAL AND/OR ELECTROLYTIC SURFACE TREATMENT**

(30) Priority: 27.07.2017 GB 201712068
(71) Applicant: Semsysco GmbH, 5020 Salzburg (AT)
(72) Inventor: Gleissner, Andreas, 9873 Döbriach (AT); Markut, Franz, 9423 St. Georgen (AT); Ötzlinger, Herbert, 5300 Hallwang (AT)
(74) Representative: Maiwald Patent- und Rechtsanwaltsgesellschaft mbH

(57) **Abstract**

The invention relates to a distribution system for chemical and/or electrolytic surface treatment of a substrate in a process fluid, a device for chemical and/or electrolytic surface treatment of a substrate in a process fluid, and a distribution method for chemical and/or electrolytic surface treatment of a substrate in a process fluid.

The distribution system for chemical and/or electrolytic surface treatment comprises a distribution body and a control unit. The distribution body is configured to direct a flow of the process fluid and/or an electrical current to the substrate. The distribution body comprises at least a first distribution element and a second distribution element. The control unit is configured to control the first distribution element and the second distribution element separately.

## Description

### FIELD OF THE INVENTION

The invention relates to a distribution system for chemical and/or electrolytic surface treatment of a substrate in a process fluid, a device for chemical and/or electrolytic surface treatment of a substrate in a process fluid, and a distribution method for chemical and/or electrolytic surface treatment of a substrate in a process fluid.

### BACKGROUND OF THE INVENTION

In the semiconductor industry, various processes can be used to deposit or remove materials on or from the surface of wafers.

For example, electrochemical deposition (ECD) or electrochemical mechanical deposition (ECMD) processes can be used to deposit conductors, such as copper, on previously patterned wafer surfaces to fabricate device interconnect structures.

Chemical mechanical polishing (CMP) is commonly used for a material removal step. Another technique, electropolishing or electroetching, can also be used to remove excess materials from the surface of the wafers.

Electrochemical (or electrochemical mechanical) deposition of materials on wafer surfaces or electrochemical (or electrochemical mechanical) removal of materials from the wafer surfaces are collectively called "electrochemical processing". Electrochemical, chemical and/or electrolytic surface treatment techniques may comprise electropolishing (or electroetching), electrochemical mechanical polishing (or electrochemical mechanical etching), electrochemical deposition and electrochemical mechanical deposition. All techniques utilize a process fluid.

Chemical and/or electrolytic surface treatment techniques involve the following steps. A substrate to be processed is attached to a substrate holder, immersed into an electrolytic process fluid and serves as a cathode. An electrode is immersed into the process fluid and serves as an anode. A direct current is applied to the process fluid and dissociates positively charged metal ions at the anode. The ions then migrate to the cathode, where they plate the substrate attached to the cathode.

A problem in such a process is the formation of a uniform layer. A plating current may not be uniform when passing from an anode to a cathode of the system and/or a fluid distribution in a process chamber may not be uniform. A uniform distribution of the current and/or the flow is implemented by a distribution body, which should correspond to the substrate to be treated. Non-uniform current or fluid distribution may lead to non-uniform layer thickness.

This problem may be handled by an exact adjustment of the entire system for chemical and/or electrolytic surface treatment to a specific substrate and in particular to a specific shape and/or size of the substrate. This, however, generates the problem that the surface treatment system has to be adapted each time the substrate is changed. This adaption of the surface treatment system mainly comprises an exchange of the distribution body, which should correspond to the substrate to be treated. The adaption may further comprise a replacement of the anode. As a result, the adjustment of the entire system for chemical and/or electrolytic surface treatment to a specific substrate consumes a lot of time and money.

### SUMMARY OF THE INVENTION

Hence, there may be a need to provide an improved distribution system for chemical and/or electrolytic surface treatment of a substrate in a process fluid, which allows an easy adaption to different substrates.

The problem of the present invention is solved by the subject-matters of the independent claims, wherein further embodiments are incorporated in the dependent claims. It should be noted that the aspects of the invention described in the following apply also to the distribution system for chemical and/or electrolytic surface treatment of a substrate in a process fluid, the device for chemical and/or electrolytic surface treatment of a substrate in a process fluid, and the distribution method for chemical and/or electrolytic surface treatment of a substrate in a process fluid.

According to the present invention, a distribution system for chemical and/or electrolytic surface treatment of a substrate in a process fluid is presented. The distribution system may be a vertical distribution system with a vertical plating chamber, in which the substrate is inserted vertically. The distribution system may also be a horizontal distribution system with a horizontal plating chamber, in which the substrate is inserted horizontally.

The chemical and/or electrolytic surface treatment may be any material deposition, galvanized coating, chemical or electrochemical etching, anodal oxidation, metal separation or the like.

The substrate may comprise a conductor plate, a semi-conductor substrate, a film substrate, an essentially plate-shaped, metal or metallized workpiece or the like. A surface of the surface to be treated may be at least partially masked or unmasked.

The distribution system for chemical and/or electrolytic surface treatment comprises a distribution body and a control unit.

The distribution body is configured to direct a flow of process fluid and/or electrical current to the substrate. The distribution body may correspond to the substrate to be treated in particular in view of its shape and size.

The distribution body comprises at least a first distribution element and a second distribution element. The first distribution element and the second distribution element may be arranged to direct a flow of process fluid and/or electrical current to different portions of the substrate.

The control unit is configured to control the first distribution element and the second distribution element separately. The control unit may be a processor. The control unit may be configured to switch the second distribution element on or off separately and independently of the first distribution element to direct a flow of process fluid and/or electrical current to different portions of the substrate.

The system for chemical and/or electrolytic surface treatment according to the invention thereby allows an easy adaption of the system to different substrates and in particular to different shapes and/or sizes of the substrate. The easy adaption allows reducing and even eliminating the time required for adjusting the surface treatment system and, consequently allows reducing and even eliminating the costs for adjusting the surface treatment system. It is no longer necessary to exchange the distribution body, the anode, the process fluid supply and/or the like to different substrates. The surface treatment according to the invention further allows the formation of a uniform layer on the substrate independent of the shape and/or size of the substrate. In an example, the separate control of the first distribution element and the second distribution element is configured for a uniform deposition rate. In an example, the separate control of the first distribution element and the second distribution element is configured for a uniform surface treatment of the substrate.

For example, the first distribution element may be configured for a surface treatment of a smaller substrate or for a surface treatment of an inner portion of a larger substrate. In an example, the first distribution element corresponds to an inner circle of the distribution body. In another example, the first distribution element corresponds to an inner rectangle of the distribution body.

The second distribution element may be configured to be switched off when treating a smaller substrate or to be switched on for treating an outer portion of a larger substrate. In an example, the second distribution element corresponds to an outer element of the distribution body at least partially surrounding the first distribution element.

In other words, the first distribution element can be used for smaller substrates and a combination of the first distribution element and the second distribution element can be used for larger substrates. In case of a larger substrate, the first distribution element and the second distribution element can be switched on simultaneously or consecutively. In an example, the control unit is configured to switch the first distribution element in a first power condition and the second distribution element into a second power condition different to the first power condition.

Still in other words, the first distribution element and the second distribution element may be controlled to direct a flow of process fluid and/or electrical current to different portions of the substrate.

In an example, the first distribution element is a circle or a rectangle and the second distribution element is shaped to change the shape of the distribution body into the other of a circle or a rectangle.

The distribution body may have any kind of shape. In an example, the distribution body has a circular shape. In another example, the distribution body has an angular shape. It may also be rectangular, square, oval, or triangular, or have another suitable geometric configuration.

In an example, the distribution body further comprises at least a third distribution element and the control unit is configured to control at least two of the first distribution element, the second distribution element and the third distribution element separately. The distribution body may also comprise more than two or three distribution elements, wherein at least two of them are configured to be controlled separately.

According to the present invention, also a device for chemical and/or electrolytic surface treatment of a substrate in a process fluid is presented. The device for chemical and/or electrolytic surface treatment comprises a distribution system for chemical and/or electrolytic surface treatment of a substrate in a process fluid as described above and a substrate holder.

The substrate holder is configured to hold the substrate. The substrate holder may be configured to hold one or two substrates (one substrate on each side of the substrate holder).

The device for chemical and/or electrolytic surface treatment may further comprise an anode. The device for chemical and/or electrolytic surface treatment may further comprise a power supply. The device for chemical and/or electrolytic surface treatment may further comprise a process fluid supply.

According to the present invention, also a distribution method for chemical and/or electrolytic surface treatment of a substrate in a process fluid is presented. The method for chemical and/or electrolytic surface treatment comprises the following steps, not necessarily in this order:
a) providing a distribution body configured to direct a flow of the process fluid and/or an electrical current to the substrate, wherein the distribution body comprises at least a first distribution element and a second distribution element,
b) controlling the first distribution element, and
c) controlling the second distribution element,
   wherein the controlling of the first distribution element and the second distribution element is separate from each other.

For example, the first distribution element may be configured for a surface treatment of a smaller substrate or for a surface treatment of an inner portion of a larger substrate. The second distribution element may be configured to be switched off when treating a smaller substrate or to be switched on for treating an outer portion of a larger substrate. In other words, the first distribution element can be used for smaller substrates and a combination of the first distribution element and the second distribution element can be used for larger substrates. In case of a larger substrate, the first distribution element and the second distribution element can be switched on simultaneously or consecutively.

As a result, the invention relates to a method for chemical and/or electrolytic surface treatment, which allows an easy adaption to different substrates and in particular to different shapes and/or sizes of the substrate. The easy adaption allows reducing and even eliminating the time required for adjusting the surface treatment method and, consequently allows reducing and even eliminating the costs for adjusting the surface treatment method. The surface treatment method according to the invention further allows the formation of a uniform layer on the substrate independent of the shape and/or size of the substrate.

Devices and methods are suitable, in particular, for the processing of structured semi-conductor substrates, conductor plates, and film substrates, but also for processing of the entire surface of planar metal and metallized substrates. Device and methods may also be used according to the invention for the production of large surface photoelectric panels for solar energy generation, or large-scale monitor panels.

It shall be understood that the system, the device, and the method for chemical and/or electrolytic surface treatment of a substrate in a process fluid according to the independent claims have similar and/or identical preferred embodiments, in particular, as defined in the dependent claims. It shall be understood further that a preferred embodiment of the invention can also be any combination of the dependent claims with the respective independent claim.

These and other aspects of the present invention will become apparent from and be elucidated with reference to the embodiments described hereinafter.

### BRIEF DESCRIPTION OF THE DRAWINGS

Exemplary embodiments of the invention will be described in the following with reference to the accompanying drawings:
**Figure 1** shows schematically and exemplarily an embodiment of a device for chemical and/or electrolytic surface treatment of a substrate in a process fluid according to the invention.
**Figures 2a and 2b** show schematically and exemplarily embodiments of substrate holders holding two substrates.
**Figures 3a and 3b** show schematically and exemplarily an embodiment of a device for chemical and/or electrolytic surface treatment and a distribution system for chemical and/or electrolytic surface treatment of a substrate in a process fluid according to the invention.
**Figures 4a** and 4b show schematically and exemplarily an embodiment of substrate holders for a single substrate.
**Figure 5** shows basic steps of an example of a distribution method for chemical and/or electrolytic surface treatment of a substrate in a process fluid according to the invention.

### DETAILED DESCRIPTION OF EMBODIMENTS

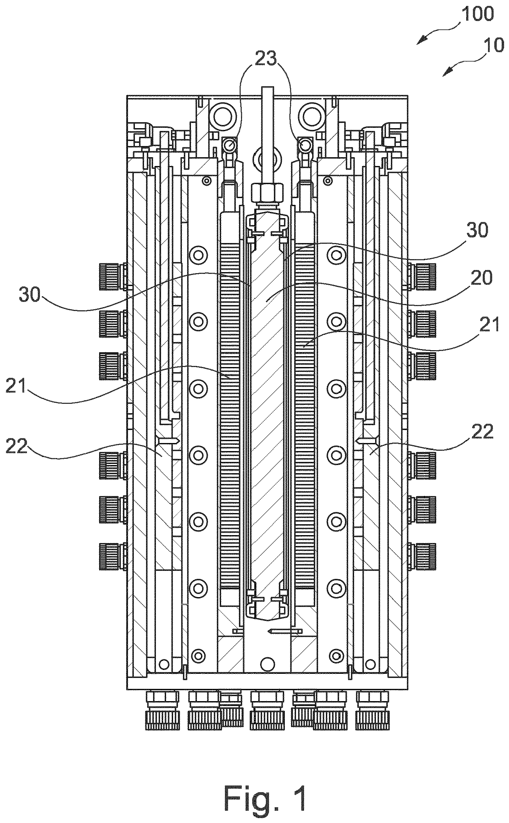

**Figure 1** shows schematically and exemplarily an embodiment of a device 100 for chemical and/or electrolytic surface treatment of a substrate 30 in a process fluid according to the invention. The device 100 for chemical and/or electrolytic surface treatment comprises a substrate holder 20 and a distribution system 10 for chemical and/or electrolytic surface treatment of the substrate 30 in a process fluid.

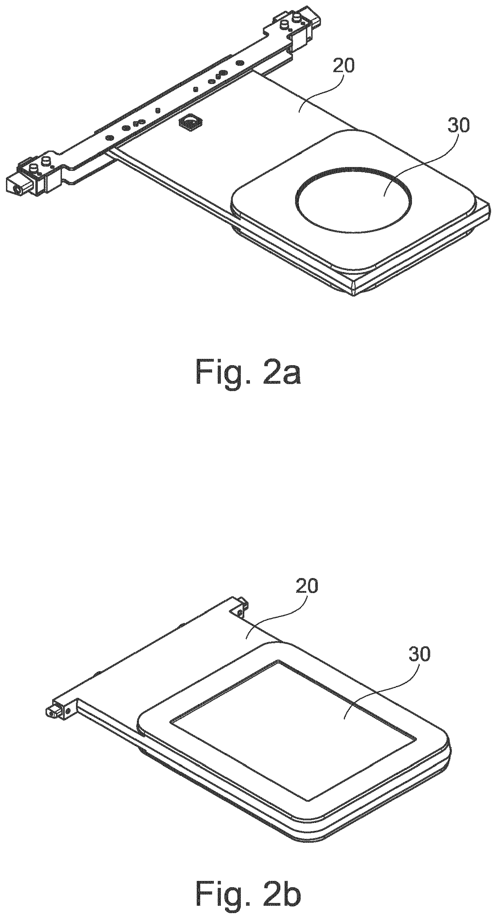

Substrate holders 20 are shown in **Figures 2a and 2b****.** They are each configured to hold substrates 30 vertically. Both substrate holders 20 hold two substrates 30, one substrate 30 on each side of the substrate holder 20. The substrate holder 20 in Figure 2a holds circular substrates 30 with e.g. a diameter of 200 mm; the substrate holder 20 in Figure 2b holds rectangular substrates 30 with a size of e.g. 370 x 470 mm. These substrate holders 20 allow using substrates of different shape and/or size without constructive modifications of the device 100 for chemical and/or electrolytic surface treatment.

Of course, the device 100 for chemical and/or electrolytic surface treatment may also be used with a substrate holder 20, which is configured to hold only one substrate 30 for single or dual side surface treatment in a preferably horizontal arrangement.

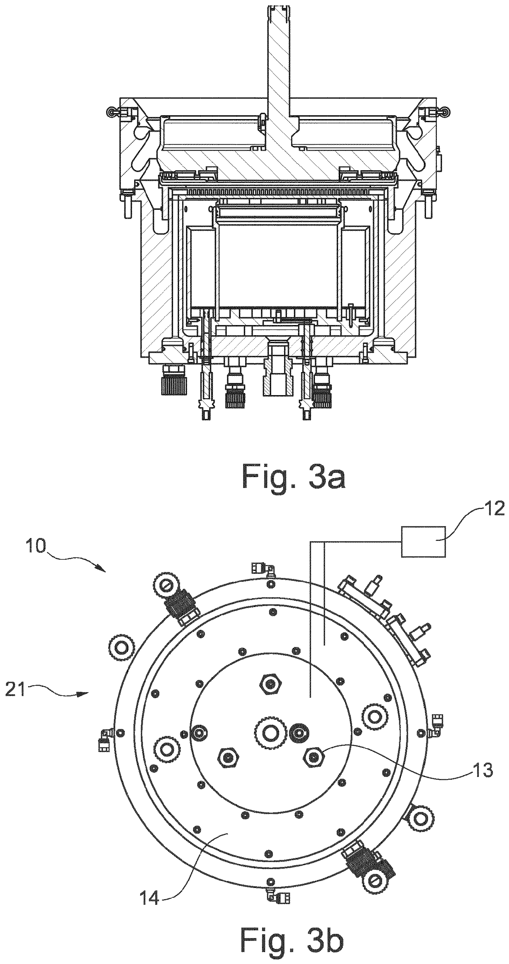

The distribution system 10 for chemical and/or electrolytic surface treatment of a substrate 30 in a process fluid as shown in **Figures 1** **and** **3** produces targeted flow and current density patterns for a chemical and/or electrolytic surface treatment. It comprises two distribution bodies 21 submerged in a process fluid (not shown). Opposite of each distribution body 21 is a substrate 30 that is attached to a substrate holder 20. The surface of the substrate 30 is wetted by the process fluid. Two electrodes, here two anodes 22, are present, which each are located on a side of the distribution body 21 opposite of the substrate 30, and which are also bathed in the process fluid.

The distribution body 21 has at least one inlet opening 23 for the process fluid and at least one liquid passage ending at an outlet nozzle array (not shown) at a front face of the distribution body 21. The pumped process fluid flows through the outlet nozzles at a relatively high speed in the direction of the substrate 30 and carries out the desired chemical and/or electrolytic reaction at that location.

The distribution body 21 may advantageously consist of plastic, in particularly advantageous manner of polypropylene, polyvinyl chloride, polyethylene, acrylic glass, i.e. polymethyl methacrylate, polytetrafluoroethylene, or another material that will not be decomposed by the process fluid.

The substrate 30 may be an essentially plate-shaped workpiece for the production of electric or electronic components, which is mechanically fixed in a substrate holder 20, and the surface of which to be treated is bathed in the process fluid as the treatment medium coming from the distribution body 21. In a special case, the substrate 30 may be a masked or unmasked conductor plate, a semi-conductor substrate, or a film substrate, or even any metal or metallized workpiece having an approximately planar surface.

The anode 22 is attached in a rear region of the distribution body 21, in mechanical contact with, or spatially separated from, the distribution body 21 such that the electric current flow is carried out between the anode 22 and the substrate 30 acting as counter electrode within the process fluid. Depending on the surface treatment method used, the anode 22 may consist of a material that is insoluble in the process liquid, such as platinizized titanium, or otherwise a soluble material, such as for example, the metal to be galvanically separated.

**Figure 3a** shows schematically and exemplarily a cross section of a device 100 for chemical and/or electrolytic surface treatment of a horizontally arranged substrate 30 in a process fluid. **Figure 3b** shows the distribution system 10 for chemical and/or electrolytic surface treatment of the substrate 30 (not shown in Figure 3b) in a process fluid according to the invention. The distribution system 10 for chemical and/or electrolytic surface treatment comprises a distribution body 21 and a control unit 12.

The distribution body 21 directs a flow of process fluid and/or electrical current to the substrate 30 and corresponds to the substrate 30 to be treated in particular in view of its shape and size. The distribution body 21 comprises here a first distribution element 13 and a second distribution element 14. The first distribution element 13 and the second distribution element 14 are arranged to direct a flow of process fluid and/or electrical current to different portions of the substrate 30.

The control unit 12 controls the first distribution element 13 and the second distribution element 14 separately and independently, which means the control unit 12 may e.g. switch the second distribution element 14 on or off separately and independently of the first distribution element 13 to direct a flow of process fluid and/or electrical current to different portions of the substrate 30.

The first distribution element 13 is here configured for a surface treatment of a smaller substrate 30 or for a surface treatment of an inner portion of a larger substrate 30. The first distribution element 13 here corresponds to an inner circle of the distribution body 21.

The second distribution element 14 is here configured to be switched off when treating a smaller substrate 30 or to be switched on for treating an outer portion of a larger substrate 30. The second distribution element 14 here corresponds to an outer ring of the distribution body 21 surrounding the first distribution element 13.

As a result, the first distribution element 13 can be used for smaller substrates and a combination of the first distribution element 13 and the second distribution element 14 can be used for larger substrates. In case of a larger substrate, the first distribution element 13 and the second distribution element 14 can be switched on simultaneously or consecutively.

The distribution system 10 for chemical and/or electrolytic surface treatment according to the invention thereby allows an easy adaption of the distribution system 10 to different substrates and in particular to different shapes and/or sizes of the substrate 30. This allows reducing and even eliminating time and costs conventionally required for adjusting the surface treatment system by replacing components of the surface treatment system. The surface treatment according to the invention further allows the formation of a uniform layer on the substrate 30 independent of the shape and/or size of the substrate 30, because it allows a uniform deposition rate and a uniform surface treatment of the substrate 30.

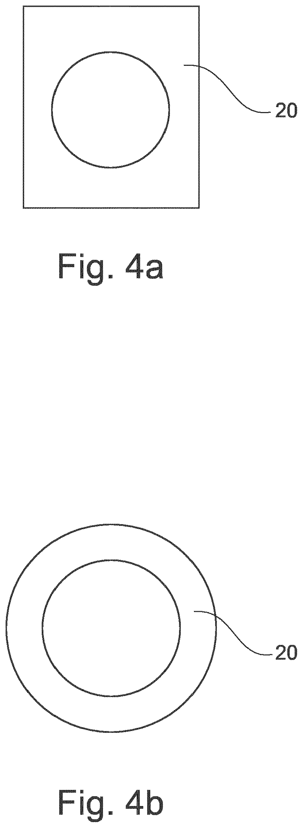

**Figure 4a** shows schematically a substrate holder 20 for a single substrate to be horizontally arranged in a device 100 for chemical and/or electrolytic surface treatment. **Figure 4b** shows schematically a substrate holder 20 for a single substrate to be vertically arranged in a device 100 for chemical and/or electrolytic surface treatment.

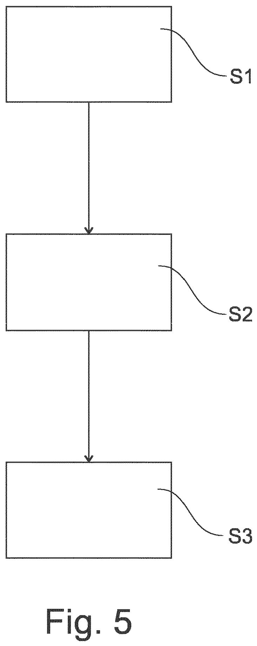

**Figure 5** shows a schematic overview of steps of a distribution method for chemical and/or electrolytic surface treatment of a substrate 30 in a process fluid. The method for chemical and/or electrolytic surface treatment comprises the following steps:
- In a first step S1, providing a distribution body 21 configured to direct a flow of the process fluid and/or an electrical current to the substrate 30, wherein the distribution body 21 comprises at least a first distribution element 13 and a second distribution element 14.
- In a second step S2, controlling the first distribution element 13.
- In a third step S3, controlling the second distribution element 14.

The controlling of the first distribution element 13 and the second distribution element 14 is separate from each other.

It has to be noted that embodiments of the invention are described with reference to different subject matters. In particular, some embodiments are described with reference to method type claims whereas other embodiments are described with reference to the device type claims. However, a person skilled in the art will gather from the above and the following description that, unless otherwise notified, in addition to any combination of features belonging to one type of subject matter also any combination between features relating to different subject matters is considered to be disclosed with this application. However, all features can be combined providing synergetic effects that are more than the simple summation of the features.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing a claimed invention, from a study of the drawings, the disclosure, and the dependent claims.

In the claims, the word "comprising" does not exclude other elements or steps, and the indefinite article "a" or "an" does not exclude a plurality. A single processor or other unit may fulfil the functions of several items re-cited in the claims. The mere fact that certain measures are re-cited in mutually different dependent claims does not indicate that a combination of these measures cannot be used to advantage. Any reference signs in the claims should not be construed as limiting the scope.

## Claims

1. A distribution system (10) for chemical and/or electrolytic surface treatment of a substrate (30) in a process fluid, comprising:
- a distribution body (21), and
- a control unit (12),
wherein the distribution body (21) is configured to direct a flow of the process fluid and/or an electrical current to the substrate (30),
wherein the distribution body (21) comprises at least a first distribution element (13) and a second distribution element (14), and
wherein the control unit (12) is configured to control the first distribution element and the second distribution element (14) separately.

2. System (10) according to claim 1, wherein the separate control of the first distribution element (13) and the second distribution element (14) is configured for an adaption of the distribution body (21) to different substrates (30).

3. System (10) according to claim 1 or 2, wherein the distribution body (21) has a circular shape.

4. System (10) according to claim 1 or 2, wherein the distribution body (21) has an angular shape.

5. System (10) according to one of the claims 1 to 4, wherein the first distribution element (13) corresponds to an inner circle of the distribution body (21).

6. System (10) according to one of the claims 1 to 4, wherein the first distribution element (13) corresponds to an inner rectangle of the distribution body (21).

7. System (10) according to one of the preceding claims, wherein the second distribution element (14) corresponds to an outer element of the distribution body (21) at least partially surrounding the first distribution element (13).

8. System (10) according to claim 1 or 2, wherein the first distribution element (13) is a circle or a rectangle and the second distribution element (14) is shaped to change the shape of the distribution body (21) into the other of a circle or a rectangle.

9. System (10) according to one of the preceding claims, wherein the control unit (12) is configured to switch the first distribution element (13) in a first power condition and the second distribution element (14) into a second power condition different to the first power condition.

10. System (10) according to one of the preceding claims, wherein the separate control of the first distribution element (13) and the second distribution element (14) is configured for a uniform surface treatment of the substrate (30).

11. System (10) according to one of the preceding claims, wherein the separate control of the first distribution element (13) and the second distribution element (14) is configured for a uniform deposition rate.

12. System (10) according to one of the preceding claims, wherein the distribution body (21) further comprises at least a third distribution element, and the control unit (12) is configured to control at least two of the first distribution element (13), the second distribution element (14) and the third distribution element separately.

13. A device (100) for chemical and/or electrolytic surface treatment of a substrate (30) in a process fluid, comprising:
- a distribution system (10) according to one of the proceeding claims, and
- a substrate holder (20),
wherein the substrate holder is configured to hold the substrate (30).

14. A distribution method for chemical and/or electrolytic surface treatment of a substrate (30) in a process fluid, comprising the following steps:
- providing a distribution body (21) configured to direct a flow of the process fluid and/or an electrical current to the substrate (30), wherein the distribution body (21) comprises at least a first distribution element (13) and a second distribution element (14),
- controlling the first distribution element (13), and
- controlling the second distribution element (14),
wherein the controlling of the first distribution element (13) and the second distribution element (14) is separate from each other.
